# EUROPEAN PATENT APPLICATION

(11) **EP 4 075 298 A1**
(43) Date of publication of application: **19.10.2022**
(21) Application number: 20913312.3
(22) Date of filing: 19.01.2020
(51) Int. Cl.: G06F 16/36, G06N 5/00

(54) **GRAPH-BASED INDUSTRIAL FLOW MODEL BUILDING SYSTEM, DEVICE, AND METHOD**

(71) Applicant: Siemens Aktiengesellschaft, 80333 München (DE)
(72) Inventor: ZOU, Wenchao, Shanghai 123200 (CN); WANG, Haifeng, Shanghai 201105 (CN); JIA, Shaotu, Fuxin, Liaoning 123200 (CN)
(74) Representative: Isarpatent
(86) International application number: PCT/CN2020/073045
(87) International publication number: WO 2021/142845

(57) **Abstract**

The present invention provides a graph-based industrial flow model building method. The method includes the following steps: importing a set of entities which are based on one industrial flow, to build a graph-based model for the industrial flow; querying the graph-based model for the industrial flow for a user-defined entity, and if the user-defined entity is found, obtaining a connection of the user-defined entity, otherwise generating a new implementation layer; querying the model for an implementation layer of the user-defined entity, and if the implementation layer of the user-defined entity is found, obtaining a connection of the implementation layer of the user-defined entity, otherwise generating a new implementation layer; and querying the model for a system-defined entity, and if the system-defined entity is found, obtaining a connection of the system-defined entity, otherwise generating a new implementation layer. The present invention makes it possible to generate an intermediate layer in the user-defined entity and the system-defined entity, which can prevent ambiguity of a flow and logic in an industrial flow model.

## Description

### Technical Field

The present invention relates to the field of industrial modeling, and in particular, to a graph-based industrial flow model building system, apparatus, and method.

### Background Art

An industrial manufacture procedure such as a technological flow can be decomposed into a series of entities and their interconnections in a graph-based model. The entities include materials, devices, etc. Most entities can be divided into two categories, namely, system-defined entities and user-defined entities. where the system-defined entities are reusable, and the user-defined entities are partially reusable or even used only once.

The industrial manufacture procedure includes an executable process or a production process, which has a clear flow or logic to show causal and sequential relationships among connections of a plurality of entities. As a result, the connections of entities in the industrial manufacture procedure must follow the flow direction, and the presentation of the industrial manufacture procedure must follow the principle, such that its flow or logic can be replicated. Moreover, the industrial manufacture procedure must also obey the principle of direction, and the direction of connections of its entities must conform to the process sequence. In addition, the industrial manufacture procedure must comply with a no-loop principle of an allowable bidirectional connection between two entities, and an independence principle of an allowable multi-connection between two entities.

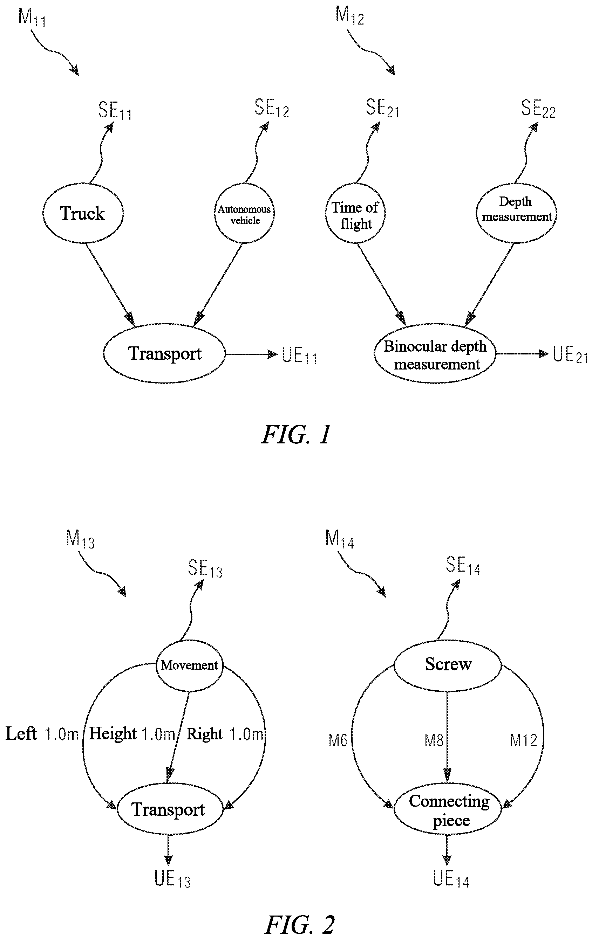

In most cases, tools and tasks are user-defined entities. However, when a user-defined entity can be described by two different system-defined entities, the direction of connection of three entities may lead to ambiguity, that is to say, the same user-defined entity is defined by two system-defined entities. Although it is intended to describe two industrial processes, the two industrial processes are presented directly in one semantic model as if they are one process. For example, as shown in FIG. 1, in a model M₁₁, a user-defined entity UE₁₁ is "transport", which can be implemented by two system-defined entities, namely, a system-defined entity SE₁₁ "truck" and a system-defined entity SE₁₂ "autonomous vehicle", respectively. For example, in a model M₁₂, a user-defined entity UE₂₁ is "depth measurement", which can be implemented by two system-defined entities, namely, a system-defined entity SE₂₁ "time of flight" and a system-defined entity SE₂₂ "binocular depth measurement", respectively.

If the same user-defined entity is described by the same system-defined entity having different parameters in different manufacture procedures, the presence of different parameters in the same manufacture procedure seems to indicate that there are different manufacture procedures, thus also causing ambiguity. As shown in FIG. 2, in a model M₁₃, a user-defined entity DE₁₃ "transport" is performed by a "movement" function of a user-defined entity SE₁₃ in three manufacture procedures, and there are three different parameters as follows: left 1.0 m, height 1.0 m, and back 1.0 m. The above three different parameters represent an action of moving 1 meter to the left, a movement at a height of 1 meter, and an action of moving back 1 meter, respectively. However, it appears that the three movements are performed at the same time. Even if a user can understand that the three movements are performed separately, the sequence of the three movements cannot be derived. For another example, in a model M₁₄, a user-defined entity UE₁₄ "connecting piece" is a system-defined entity SE₁₄ "screw". Since there are three different parameters "M6", "M8" and "M12", it seems that three "screws" of different sizes, which are screws with diameters of M6, M8 and M12 respectively, are used.

As a result, based on the above description, the causal and sequential relationships among the entities of the industrial manufacture procedure provided in the prior art cannot be correctly presented, and are hardly identified due to extremely confusing and illogical inferences and reasoning made based on the connections among the plurality of entities.

### Summary of the Invention

A first aspect of the present invention provides a graph-based industrial flow model building method, the method including the following steps: importing a set of entities which are based on one industrial flow, to build a graph-based model for the industrial flow, where the set of entities includes a user-defined entity and a system-defined entity; querying the graph-based model for the industrial flow for the user-defined entity, and if the user-defined entity is found, obtaining a connection of the user-defined entity, otherwise generating a new implementation layer; querying the model for an implementation layer of the user-defined entity, and if the implementation layer of the user-defined entity is found, obtaining a connection of the implementation layer of the user-defined entity, otherwise generating a new implementation layer; and querying the model for the system-defined entity, and if the system-defined entity is found, obtaining a connection of the system-defined entity, otherwise generating a new implementation layer, and iteratively performing the above steps until a final graph-based model for the industrial flow is obtained.

Further, the set of entities includes a user-defined entity, a system-defined entity and a parameter, and the industrial flow model building method further includes the following step: querying the model for the parameter, and if the parameter is not found, generating a new implementation layer.

Further, before the importing step, the method further includes the following steps: analyzing the industrial flow and decomposing the industrial flow into a plurality of entities, the entities including user-defined entities, system-defined entities and parameters; and dividing the plurality of entities into sets, each set of entities including a user-defined entity and a system-defined entity, or a user-defined entity, a system-defined entity and a parameter, where each set of entities represents a different industrial process.

Further, the industrial flow includes a plurality of sets of entities, where after the set dividing step, the method further includes the following step: sorting the plurality of sets of entities of the industrial flow.

Further, the industrial flow model building method further includes the following step: connecting one implementation layer to another implementation layer to indicate that the implementation layer is implemented by another implementation layer.

A second aspect of the present invention provides a graph-based industrial flow model building system, the system including: a processor; and a memory coupled to the processor, where the memory stores instructions that, when executed by the processor, cause an electronic device to perform actions including: importing a set of entities which are based on one industrial flow, to build a graph-based model for the industrial flow, where the set of entities includes a user-defined entity and a system-defined entity; querying the graph-based model for the industrial flow for the user-defined entity, and if the user-defined entity is found, obtaining a connection of the user-defined entity, otherwise generating a new implementation layer; querying the model for an implementation layer of the user-defined entity, and if the implementation layer of the user-defined entity is found, obtaining a connection of the implementation layer of the user-defined entity, otherwise generating a new implementation layer; and querying the model for the system-defined entity, and if the system-defined entity is found, obtaining a connection of the system-defined entity, otherwise generating a new implementation layer, and iteratively performing the above actions until a final graph-based model for the industrial flow is obtained.

Further, the set of entities includes a user-defined entity, a system-defined entity and a parameter, and the actions further include: querying the model for the parameter, and if the parameter is not found, generating a new implementation layer. Further, before the importing action, the actions further include: analyzing the industrial flow and decomposing the industrial flow into a plurality of entities, the entities including user-defined entities, system-defined entities and parameters; and dividing the plurality of entities into sets, each set of entities including a user-defined entity and a system-defined entity, or a user-defined entity, a system-defined entity and a parameter, where each set of entities represents a different industrial process.

Further, the industrial flow includes a plurality of sets of entities, where after the set dividing action, the actions further include: sorting the plurality of sets of entities of the industrial flow.

Further, the actions further include: connecting one implementation layer to another implementation layer to indicate that the implementation layer is implemented by another implementation layer.

A third aspect of the present invention provides a graph-based industrial flow model building apparatus, the apparatus including: an importing means, which imports a set of entities which are based on one industrial flow, to build a graph-based model for the industrial flow, where the set of entities includes a user-defined entity and a system-defined entity; a first query means, which queries the graph-based model for the industrial flow for the user-defined entity, and if the user-defined entity is found, obtains a connection of the user-defined entity, otherwise generates a new implementation layer; a second query means, which queries the model for an implementation layer of the user-defined entity, and if the implementation layer of the user-defined entity is found, obtains a connection of the implementation layer of the user-defined entity, otherwise generates a new implementation layer; and a third query means, which queries the model for the system-defined entity, and if the system-defined entity is found, obtains a connection of the system-defined entity, otherwise generates a new implementation layer.

A fourth aspect of the present invention provides a computer program product tangibly stored on a computer-readable medium and including computer-executable instructions that, when executed, cause at least one processor to perform the method as described in the first aspect of the present invention.

A fifth aspect of the present invention provides a computer-readable medium having stored thereon computer-executable instructions that, when executed, cause at least one processor to perform the method as described in the first aspect of the present invention.

The present invention makes it possible to generate an intermediate layer in the user-defined entity and the system-defined entity, which can prevent ambiguity of a flow and logic in an industrial flow model. The implementation layer will be automatically generated once a user connects one system-defined entity to one user-defined entity, which indicates that the user-defined entity is implemented by one system-defined entity. Because the implementation layer is to ensure correct reflection of different processes in a graph-based industrial flow graph, any change in an entity connected to a specific intermediate layer will cause the generation of a new intermediate layer, while original unchanged entities remain the same, such that the change in the entity can be reflected in the industrial flow graph.

### Brief Description of the Drawings

FIG. 1 is a schematic diagram of a model in which one user-defined entity is defined by two system-defined entities;
FIG. 2 is a schematic diagram of a model in which a user-defined entity is defined by a system-defined entity by using three different parameters;
FIG. 3 is a schematic diagram of adding an intermediate layer to an industrial flow model by a graph-based industrial flow model building mechanism according to a specific embodiment of the present invention;
FIG. 4 is a schematic structural diagram of a graph-based industrial flow model building apparatus according to a specific embodiment of the present invention; and
FIG. 5 is a schematic structural diagram of a model in which a graph-based industrial flow mechanism is carried out according to a specific embodiment of the present invention.

### Detailed Description of Embodiments

The specific embodiments of the present invention are described below in conjunction with the accompanying drawings. The present invention provides a graph-based industrial flow model building mechanism, in which an implementation layer is added to an industrial flow model to represent that a user-defined entity is implemented by a system-defined entity, such that the user-defined entity is in a one-to-one correspondence with the system-defined entity, thus distinguishing them during reuse in different industrial flows. Once the system-defined entity or a parameter corresponding to an implementation mode of the user-defined entity is changed, a new implementation layer will be generated.

The present invention makes it possible to generate an intermediate layer in the user-defined entity and the system-defined entity, which can prevent ambiguity of a flow and logic in an industrial flow model. The implementation layer will be automatically generated once a user connects one system-defined entity to one user-defined entity, which indicates that the user-defined entity is implemented by one system-defined entity. Because the implementation layer is to ensure correct reflection of different processes in a graph-based industrial flow graph, any change in an entity connected to a specific intermediate layer will cause the generation of a new intermediate layer, while original entities remain unchanged, such that the change in the entity can be reflected in the industrial flow graph.

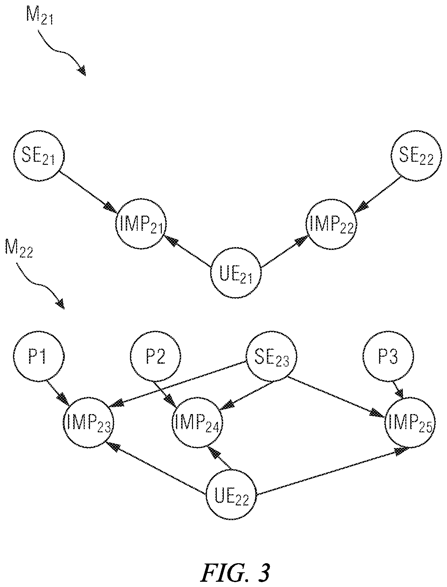

As shown in FIG. 3, according to the graph-based industrial flow model building mechanism provided in the present invention, in a model M₂₁, although one user-defined entity UE₂₁ can be implemented by two system-defined entities SE₂₁ and SE₂₂, respectively, one intermediate layer is added to distinguish between each different system-defined entity and the same user-defined entity in the present invention. In other words, an intermediate layer IMP₂₁ is set between the user-defined entity UE₂₁ and the system-defined entity SE₂₁, and an intermediate layer IMP₂₂ is set between the user-defined entity UE₂₁ and the system-defined entity SE₂₂.

As shown in FIG. 3, according to the graph-based industrial flow model building mechanism provided in the present invention, in the model M₂₁, although there are three different parameters between a user-defined entity UE₂₂ and a system-defined entity SE₂₃, an intermediate layer is added, for each parameter, among the user-defined entity, the system-defined entity and a parameter in the present invention. In other words, an intermediate layer IMP₂₃ is set among a parameter P₁, the user-defined entity UE₂₂ and the system-defined entity SE₂₃, an intermediate layer IMP₂₄ is set among a parameter P₂, the user-defined entity UE₂₂ and the system-defined entity SE₂₃, and an intermediate layer IMP₂₅ is set among a parameter P₃, the user-defined entity UE₂₂ and the system-defined entity SE₂₃.

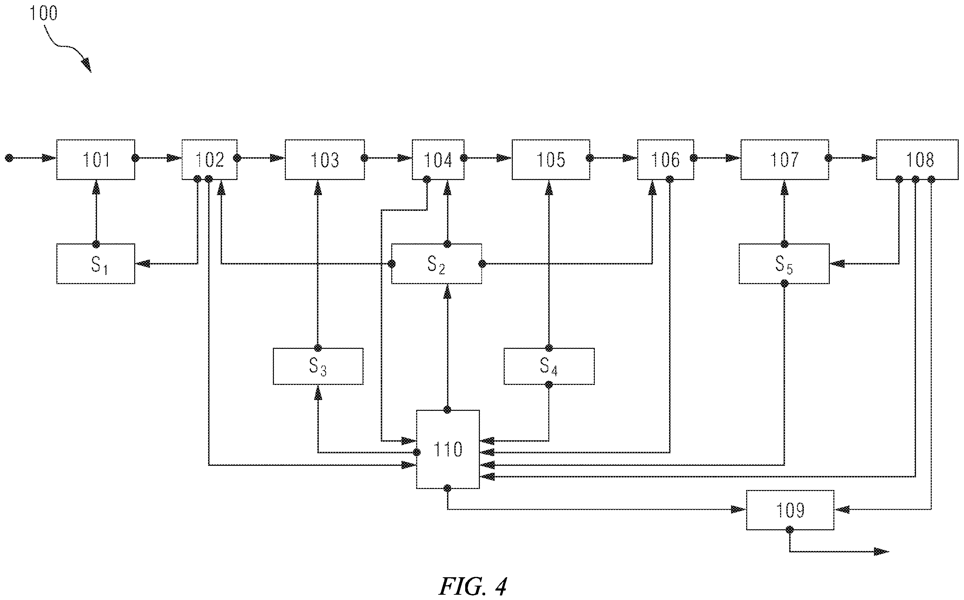

A first aspect of the present invention provides a graph-based industrial flow model building method, the method including the steps as follows. As shown in FIG. 4, a graph-based industrial flow model building apparatus 100 provided in the present invention includes a user-defined entity filter 101, a first selector 102, an implementation layer filter 103, a second selector 104, a system-defined entity filter 105, a third selector 106, a parameter filter 107, a fourth selector 108, an implementation layer releaser 109, an implementation layer generator 110, a user-defined entity storage S₁, a connection storage S₂, an implementation layer storage S₃, a system-defined entity storage S₄, and a parameter storage S₅. First, step A1 is performed, in which step a set of entities based on one industrial flow are imported in the user-defined entity filter 101 to build a graph-based model for the industrial flow, where the set of entities includes a user-defined entity and a system-defined entity. According to an embodiment of the present invention, it is assumed that the input set of entities includes one user-defined entity UE₂₁ as shown in FIG. 3 and a system-defined entity SE₂₁ corresponding to the user-defined entity UE₂₁, to build the graph-based model for the industrial flow, which is a model M₂₁. Exemplarily, the user-defined entity UE₂₁ is "transport", which can be implemented by two system-defined entities, namely, a system-defined entity SE₂₁ "truck" and a system-defined entity SE₂₂ "autonomous vehicle", respectively. However, in the present invention, each time a set of entities needs to be input, namely, one user-defined entity and one system-defined entity that correspond to each other, the user-defined entity UE₂₁ and the system-defined entity SE₂₁ are input for the first time in this embodiment.

Then, step A2 is performed, in which step the graph-based model M₂₁ for the industrial flow is queried for the user-defined entity UE₂₁ "transport", and if the user-defined entity UE₂₁ "transport" is found, a connection of the UE₂₁ "transport" is obtained, otherwise a new implementation layer is generated.

Specifically, the user-defined entity storage S₁ is queried to find out whether the user-defined entity UE₂₁ "transport" exists therein, and if the user-defined entity UE₂₁ "transport" exists in the user-defined entity storage S₁, the user-defined entity UE₂₁ "transport" is obtained from the user-defined entity storage S₁ and the connection of the user-defined entity UE₂₁ "transport" is obtained from the connection storage S₂, and a query result is output to the first selector 102. Otherwise, a query result is output to the first selector 102 and a new implementation layer is generated by the implementation layer generator 110.

If the user-defined entity UE₂₁ "transport" can be found, then step A3 is performed, in which step the model M₂₁ is queried for an implementation layer IMP₂₁ of the user-defined entity UE₂₁ "transport", and if the implementation layer IMP₂₁ of the user-defined entity UE₂₁ "transport" can be found, a connection of the implementation layer IMP₂₁ of the user-defined entity UE₂₁ "transport" is obtained, otherwise a new implementation layer is generated.

Specifically, it is queried in the implementation layer filter 103 to find out whether the implementation layer IMP₂₁ of the user-defined entity UE₂₁ "transport" exists, and if the implementation layer IMP₂₁ of the user-defined entity UE₂₁ "transport" exists in the implementation layer storage S₃, the implementation layer IMP₂₁ is obtained from the implementation layer storage S₃ and the connection of the implementation layer IMP₂₁ is acquired obtained from the connection storage S₂, and a query result is output to the second selector 104. Otherwise, a query result is output to the second selector 104 and a new implementation layer is generated by the implementation layer generator 110.

Next, step A4 is performed, in which step the model M₂₁ is queried for a system-defined entity SE₂₁ "truck", and if the system-defined entity SE₂₁ "truck" can be found, a connection of the system-defined entity SE₂₁ "truck" is obtained, otherwise a new implementation layer is generated. Specifically, it is queried in the system-defined entity filter 105 to find out whether the system-defined entity SE₂₁ "truck" exists, and if the system-defined entity SE₂₁ "truck" exists in the system-defined entity storage S₄, the system-defined entity SE₂₁ "truck" is obtained from the system-defined entity storage S₄ and the connection of the system-defined entity SE₂₁ "truck" is obtained from the connection storage S₂, and a query result is output to the third selector 106. Otherwise, a query result is output to the third selector 106 and a new implementation layer is generated by the implementation layer generator 110. The implementation layer is released by the implementation layer releaser 109.

By performing steps A1, A2, A3 and A4, the present invention can determine such an industrial flow in which the user-defined entity UE₂₁ "transport" is implemented by the system-defined entity SE₂₁ "truck". The implementation layer IMP₂₁ is set between the user-defined entity UE₂₁ "transport" and the system-defined entity SE₂₁ "truck", and is used to indicate a unique relationship between the user-defined entity UE₂₁ "transport" and the system-defined entity SE₂₁ "truck". Once any of the user-defined entity UE₂₁ "transport", the system-defined entity SE₂₁ "truck", and the implementation layer IMP₂₁ is not found in the model M₂₁, it is ensured that the logic and sequence of the user-defined entity UE₂₁ "transport" and the system-defined entity SE₂₁ "truck" is determined by a unique intermediate layer. Once there is any change in any entity, a new intermediate layer is generated.

The above steps A1, A2 and A3 are iteratively performed until a final graph-based model M₂₁ for the industrial flow is obtained. In this embodiment, following the user-defined entity UE₂₁ "transport", the system-defined entity SE₂₁, and the implementation layer IMP₂₁, a second set of entities is then imported, where the second set of entities includes the user-defined entity UE₂₁ and a system-defined entity SE₂₂ "autonomous vehicle". The graph-based model M₂₁ for the industrial flow is queried for the user-defined entity UE₂₁ "transport", and if the user-defined entity UE₂₁ "transport" can be found, a connection of the UE₂₁ "transport" is obtained. Then, the model M₂₁ is queried for an implementation layer IMP₂₂ of the user-defined entity UE₂₁ "transport", and if the implementation layer IMP₂₂ of the user-defined entity UE₂₁ "transport" can be found, a connection of the implementation layer IMP₂₂ of the user-defined entity UE₂₁ "transport" is obtained. Next, the model M₂₁ is queried for the system-defined entity SE₂₂ "autonomous vehicle", and if the system-defined entity SE₂₂ "autonomous vehicle" can be found, a connection of the system-defined entity SE₂₂ "autonomous vehicle" is obtained. If any of the user-defined entity UE₂₁ "transport", the system-defined entity SE₂₁, and the implementation layer IMP₂₁ cannot be found, a new implementation layer is generated immediately. The implementation layer IMP₂₂ is set between the user-defined entity UE₂₁ "transport" and the system-defined entity SE₂₂ "autonomous vehicle", and is used to indicate a unique relationship between the user-defined entity UE₂₁ "transport" and the system-defined entity SE₂₂ "autonomous vehicle". After the above entities are all determined, the final graph-based model M₂₁ for the industrial flow can be determined.

Further, according to different application scenarios, the graph-based model for the industrial flow includes different parameters, in addition to the user-defined entities and the system-defined entities. The set of entities further includes a user-defined entity, a system-defined entity and a parameter. According to another embodiment of the present invention, in a model M₂₂, a user-defined entity UE₂₂ "connecting piece" is implemented by a system-defined entity SE₂₃ "screw". There are three different parameters "M6", "M8" and "M12", which represent screws with diameters of M6, M8 and M12, respectively. However, the user-defined entity UE₂₂ "connecting piece" is implemented by the system-defined entity SE₂₃ "screw" with the diameter of M6, the user-defined entity UE₂₂ "connecting piece" is implemented by the system-defined entity SE₂₃ "screw" with the diameter of M8, and the user-defined entity UE₂₂ "connecting piece" is implemented by the system-defined entity SE₂₃ "screw" with the diameter of M12, which represent three different industrial flows, respectively, and should thus be distinguished.

Thus, in the iteratively performed step A1, the first set of entities imported in the user-defined entity filter 101 includes the user-defined entity UE₂₂ "connecting piece", the system-defined entity SE₂₃ "screw" and the parameter P1 "M6", then the second set of entities imported in the user-defined entity filter 101 includes the user-defined entity UE₂₂ "connecting piece", the system-defined entity SE₂₃ "screw" and the parameter P2 "M8", and finally the third set of entities imported in the user-defined entity filter 101 includes the user-defined entity UE₂₂ "connecting piece", the system-defined entity SE₂₃ "screw" and the parameter P3 "M12". Steps A2, A3 and A4 are used to determine the logic and sequence of the user-defined entity UE₂₂ "connecting piece" and the system-defined entity SE₂₃ "screw", which are similar to those described in the above embodiment, and will not be repeated for the sake of brevity.

After the above steps are iteratively performed, it can be determined that the user-defined entity UE₂₂ "connecting piece" and the system-defined entity SE₂₃ "screw" exist in the model M₂₂, and there are three implementation layers between the user-defined entity UE₂₂ "connecting piece" and the system-defined entity SE₂₃ "screw", which are respectively an implementation layer IMP₂₃, an implementation layer IMP₂₄, and an implementation layer IMP₂₅.

After step A4, the method further includes the following step A5:
the model M₂₂ is queried for the parameter P1 "M6", and if the parameter P1 cannot be found, a new implementation layer is generated. Specifically, it is queried in the parameter filter 107 to find out whether the parameter P1 "M6" exists, and if the parameter P1 "M6" exists in the parameter storage S₅, the parameter P1 "M6" is obtained from the parameter storage S₅, and a query result is output to the second selector 104.

Otherwise, a query result is output to the fourth selector 108 and a new implementation layer is generated by the implementation layer generator 110.

Similarly, the model M₂₂ is queried for the parameter P2 "M8", and if the parameter P1 cannot be found, a new implementation layer is generated. Specifically, it is queried in the parameter filter 107 to find out whether the parameter P2 "M8" exists, and if the parameter P2 "M8" exists in the parameter storage S₅, the parameter P2 "M8" is obtained from the parameter storage S₅, and a query result is output to the second selector 104. Otherwise, a query result is output to the fourth selector 108 and a new implementation layer is generated by the implementation layer generator 110. Similarly, the model M₂₂ is queried for the parameter P3 "M12", and if the parameter P3 cannot be found, a new implementation layer is generated. Specifically, it is queried in the parameter filter 107 to find out whether the parameter P3 "M12" exists, and if the parameter P3 "M12" exists in the parameter storage S₅, the parameter P3 "M12" is obtained from the parameter storage S₅, and a query result is output to the second selector 104. Otherwise, a query result is output to the fourth selector 108 and a new implementation layer is generated by the implementation layer generator 110.

After the above steps are performed, the model M₂₂ is output.

Preferably, before step A1, the method further includes the following steps: analyzing the industrial flow and decomposing the industrial flow into a plurality of entities, the entities including user-defined entities, system-defined entities and parameters; and dividing the plurality of entities into sets, each set of entities including a user-defined entity and a system-defined entity, or a user-defined entity, a system-defined entity and a parameter, where each set of entities represents a different industrial process.

Further, the industrial flow includes a plurality of sets of entities, where after the set dividing step, the method further includes the following step: sorting the plurality of sets of entities of the industrial flow.

For example, the industrial flow as shown in FIG. 3 is decomposed into three entities, which are respectively the user-defined entity UE₂₁ "transport", the system-defined entity SE₂₁ "truck", and the system-defined entity SE₂₂ "autonomous vehicle". Moreover, the above entities are divided into sets, where a first set of entities includes the user-defined entity UE₂₁ "transport" and the system-defined entity SE₂₁ "truck", and a second set of entities includes the user-defined entity UE₂₁ "transport" and the system-defined entity SE₂₂ "autonomous vehicle". Then, the above two sets of entities are sorted. Optionally, the first set of entities that includes the user-defined entity UE₂₁ "transport" and the system-defined entity SE₂₁ "truck" is imported first, and then the second set of entities that includes the user-defined entity UE₂₁ "transport" and the system-defined entity SE₂₂ "autonomous vehicle" is imported.

For example, the industrial flow as shown in FIG. 3 is decomposed into five entities, which are respectively the user-defined entity UE₂₂ "connecting piece", and the system-defined entity SE₂₃ "screw" and its parameter P1 "M6", parameter P2 "M8" and parameter P3 "M12". Then, the above entities are divided into sets, where a first set of entities includes the user-defined entity UE₂₂ "connecting piece", and the system-defined entity SE₂₃ "screw" and its parameter P1 "M6", a second set of entities includes the user-defined entity UE₂₂ "connecting piece", and the system-defined entity SE₂₃ "screw" and its parameter P2 "M8", and a third set of entities includes the user-defined entity UE₂₂ "connecting piece", and the system-defined entity SE₂₃ "screw" and its parameter P3 "M12". Then, the above two sets of entities are sorted. Optionally, the first set of entities is imported first, then the second set of entities is imported, and finally the third set of entities is imported.

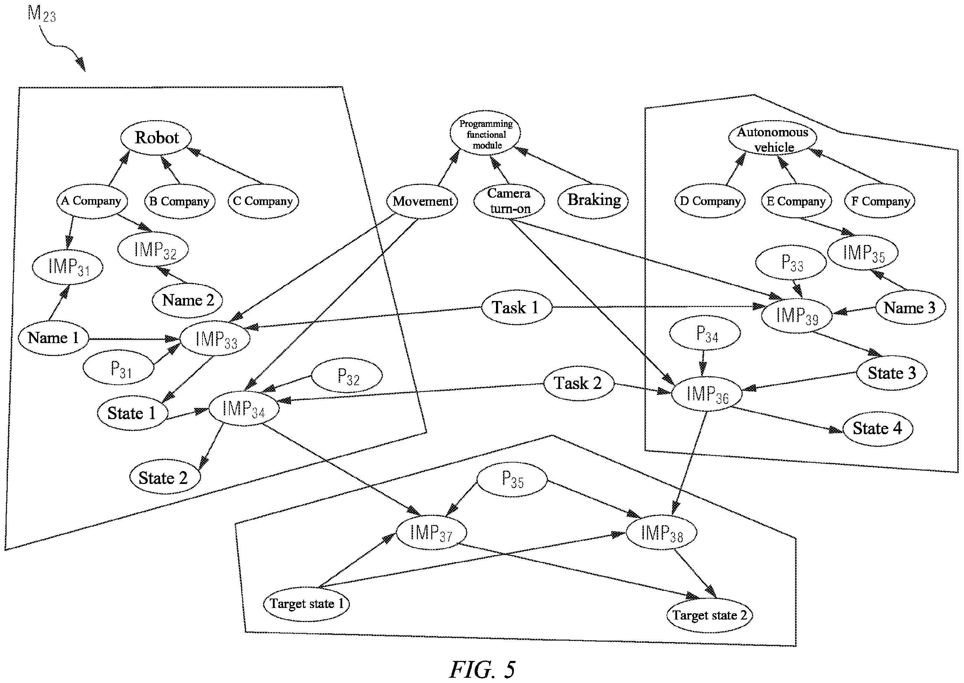

FIG. 5 is a schematic structural diagram of a model in which a graph-based industrial flow mechanism is carried out according to a specific embodiment of the present invention. In this embodiment, the industrial flow includes two different processes, one of which involves moving an object by a robot of company A that is named "name 1". The robot "name 1" is performed, but no movement occurs. The robot "name 1" is performed twice by implementation layers IMP₃₃ and IMP₃₄ by using a movement module of a programming functional module. The object is moved by an implementation layer IMP₃₇ that is implemented by the implementation layer IMP₃₄. Moreover, the autonomous vehicle has moved twice by an implementation layer IMP₃₅ and an implementation layer IMP₃₆ by using the same movement module, and the implementation layer IMP₃₆ performs an implementation layer IMP₃₈ to move the same object.

Therefore, in this embodiment, there are both entities that are repeated in the same process and entities that are repeated in different processes, and there are different processes that coexist in the same model, and the above processes are also connected to each other through the entities. Implementation of the present invention can make the causal and logical relationships of the industrial flow very clear.

A model M₂₃ output after the implementation of the present invention is as shown in FIG. 5. System-defined entities include a robot, companies A, B and C that provide the robot, an autonomous vehicle, companies D, E and F that provide the autonomous vehicle, and a programming functional module and its submodules for movement, camera turn-on and braking. User-defined entities include names 1 and 2 of the robot, states 1 and 2 of the robot, name 3 of the autonomous vehicle, states 3 and 4 of the autonomous vehicle, and tasks 1 and 2. Moreover, there are a plurality of parameters in the model M₂₃, which are respectively a parameter P₃₁, a parameter P₃₂, a parameter P₃₃, a parameter P₃₄, and a parameter P₃₅. Each parameter includes the left of an x-axis, a y-axis and a z-axis, and an angle of rotation about each of the x-axis, y-axis and z-axis, as well as a velocity and an acceleration.

Specifically, the parameter P₃₁ represents the transformation of the robot "name 1" from an initial attitude to a target attitude, where in the initial attitude, three-dimensional coordinates of an initial position of the robot are as follows: x = -1.8; y = 0; and z = 0, with an angle of rotation about z being 1.07, an angle of rotation about y being 0, an angle of rotation about x being 0, the velocity of the robot's movement being 0.2, and the acceleration being 0.1. Similarly, the parameter P₃₂ also represents the transformation of the robot "name 1" from an initial attitude to a target attitude. The robot switches from "state 1" indicated by the parameter P₃₁ to "state 2" indicated by the parameter P₃₂, which is implemented by a "movement" module of the programming functional module.

Specifically, the parameter P₃₃ represents the transformation of the autonomous vehicle "name 3" from an initial attitude to a target attitude. Similarly, the parameter P₃₄ also represents the transformation of the autonomous vehicle "name 3" from an initial attitude to a target attitude. The autonomous vehicle switches from "state 3" indicated by the parameter P₃₃ to "state 4" indicated by the parameter P₃₂, which is implemented by a "camera turn-on" module of the programming functional module.

Both the autonomous vehicle and the robot can be used to move an object. The parameter P₃₅ represents the transformation of the object from an initial attitude to a target attitude, that is, from a target state 1 to a target state 2.

In the present invention, a plurality of implementation layers are set among different entities, and the implementation layers, as blank nodes, indicate logical and sequential relationships among the entities to distinguish between them. Specifically, the implementation layer IMP₃₁ is set between the system-defined entity "company A" and the user-defined entity "name 1"; the implementation layer IMP₃₂ is set between the system-defined entity "company A" and the user-defined entity "name 2"; the implementation layer IMP₃₃ connects a plurality of entities such as the system-defined entity "movement", the user-defined entities "name 1", "task 1" and "state 1", and the parameter P₃₁; the implementation layer IMP₃₄ connects a plurality of entities such as the system-defined entity "movement", the user-defined entities "state 2", "task 2" and "state 1", and the parameter P₃₂; the implementation layer IMP₃₅ is set between the system-defined entity "company E" and the user-defined entity "name 3"; the implementation layer IMP₃₆ connects a plurality of entities such as the system-defined entity "camera turn-on" and the user-defined entities "state 3", "task 2" and "state 4", and the parameter P₃₄; and an implementation layer IMP₃₉ connects a plurality of entities such as the system-defined entity "camera turn-on", the user-defined entities "name 3", "task 1" and "state 3", and the parameter P₃₃. The implementation layer IMP₃₇ is implemented by the implementation layer IMP₃₄, and the implementation layer IMP₃₈ is implemented by the implementation layer IMP₃₆. The implementation layer IMP₃₇ connects the user-defined entity "target state 1" and the parameter P₃₅, and the implementation layer IMP₃₈ connects the user-defined entity "target state 2" and the parameter P₃₅.

Preferably, the industrial flow model building method further includes the following step: connecting one implementation layer to another implementation layer to indicate that the implementation layer is implemented by another implementation layer. Therefore, the implementation layers, as the blank nodes, are not only used to indicate the sequential and logical relationships among the user-defined entities, the system-defined entities and the parameters, and the interconnected implementation layers represent that one implementation layer is implemented by another implementation layer.

The industrial flow model building mechanism provided in the present invention is efficient and represents dynamic industrial processes with static entities and their connections, where the user-defined entities and the system-defined entities are connected to each other without causing ambiguity of logic and sequence, and the causality and influence of the interconnections thereof are very clear. Specifically, the system-defined entities such as functional modules, parameters and systematic classifications, and the user-defined entities such as project names, structures and parameters can be reduced in the same repetitive process, and the user-defined entities and the system-defined entities can be used in any number of different repetitive processes. All processes in which the user-defined entities and the system-defined entities are not used can also be presented in the same model. This means that industrial flows implementing the present invention are also connected to each other, and any entity can be input, such that the user can obtain the entire process chain. For example, a task can be defined by many different actions, a tool can be defined by a plurality of different apparatuses, and the user can recommend actions and tools by utilizing the present invention to perform an industrial process with desired entities and parameters.

The present invention is also advantageous in that intermediate entities can be automatically generated and connected to the system-defined entities and the user-defined entities, so that the system-defined entities and the user-defined entities are connected to each other and repeated by entities of different implementations.

A second aspect of the present invention provides a graph-based industrial flow model building system, the system including: a processor; and a memory coupled to the processor, where the memory stores instructions that, when executed by the processor, cause an electronic device to perform actions including: importing a set of entities which are based on one industrial flow, to build a graph-based model for the industrial flow, where the set of entities includes a user-defined entity and a system-defined entity; querying the graph-based model for the industrial flow for the user-defined entity, and if the user-defined entity is found, obtaining a connection of the user-defined entity, otherwise generating a new implementation layer; querying the model for an implementation layer of the user-defined entity, and if the implementation layer of the user-defined entity is found, obtaining a connection of the implementation layer of the user-defined entity, otherwise generating a new implementation layer; and querying the model for the system-defined entity, and if the system-defined entity is found, obtaining a connection of the system-defined entity, otherwise generating a new implementation layer, and iteratively performing the above actions until a final graph-based model for the industrial flow is obtained.

Further, the set of entities includes a user-defined entity, a system-defined entity and a parameter, and the actions further include: querying the model for the parameter, and if the parameter is not found, generating a new implementation layer. Further, before the importing action, the actions further include: analyzing the industrial flow and decomposing the industrial flow into a plurality of entities, the entities including user-defined entities, system-defined entities and parameters; and dividing the plurality of entities into sets, each set of entities including a user-defined entity and a system-defined entity, or a user-defined entity, a system-defined entity and a parameter, where each set of entities represents a different industrial process.

Further, the industrial flow includes a plurality of sets of entities, where after the set dividing action, the actions further include: sorting the plurality of sets of entities of the industrial flow.

Further, the actions further include: connecting one implementation layer to another implementation layer to indicate that the implementation layer is implemented by another implementation layer.

A third aspect of the present invention provides a graph-based industrial flow model building apparatus, the apparatus including: an importing means, which imports a set of entities which are based on one industrial flow, to build a graph-based model for the industrial flow, where the set of entities includes a user-defined entity and a system-defined entity; a first query means, which queries the graph-based model for the industrial flow for the user-defined entity, and if the user-defined entity is found, obtains a connection of the user-defined entity, otherwise generates a new implementation layer; a second query means, which queries the model for an implementation layer of the user-defined entity, and if the implementation layer of the user-defined entity is found, obtains a connection of the implementation layer of the user-defined entity, otherwise generates a new implementation layer; and a third query means, which queries the model for the system-defined entity, and if the system-defined entity is found, obtains a connection of the system-defined entity, otherwise generates a new implementation layer.

A fourth aspect of the present invention provides a computer program product tangibly stored on a computer-readable medium and including computer-executable instructions that, when executed, cause at least one processor to perform the method as described in the first aspect of the present invention.

A fifth aspect of the present invention provides a computer-readable medium having stored thereon computer-executable instructions that, when executed, cause at least one processor to perform the method as described in the first aspect of the present invention.

Although the content of the present invention has been described in detail by means of the above-mentioned preferred embodiments, it should be noted that the above description should not be construed as limiting the present invention. Various modifications and substitutions to the present invention will be apparent to those skilled in the art upon reading the content above. Therefore, the scope of protection of the present invention should be defined by the appended claims. In addition, any reference sign in the claims should not be construed as limiting the claims involved. The term "include/comprise" does not exclude other apparatuses or steps not listed in the claims or the specification. The terms "first", "second", etc., are merely used to refer to names, and do not denote any particular order.

## Claims

1. A graph-based industrial flow model building method, comprising the following steps:
importing a set of entities which are based on one industrial flow, to build a graph-based model for the industrial flow,
wherein the set of entities comprises a user-defined entity and a system-defined entity;
querying the graph-based model for the industrial flow for the user-defined entity, and if the user-defined entity is found, obtaining a connection of the user-defined entity, otherwise generating a new implementation layer;
querying the model for an implementation layer of the user-defined entity, and if the implementation layer of the user-defined entity is found, obtaining a connection of the implementation layer of the user-defined entity, otherwise generating a new implementation layer; and
querying the model for the system-defined entity, and if the system-defined entity is found, obtaining a connection of the system-defined entity, otherwise generating a new implementation layer, and
iteratively performing the above steps until a final graph-based model for the industrial flow is obtained.

2. The graph-based industrial flow model building method according to claim 1, **characterized in that** the set of entities comprises a user-defined entity, a system-defined entity and a parameter, and the industrial flow model building method further comprises the following step:
querying the model for the parameter, and if the parameter is not found, generating a new implementation layer.

3. The graph-based industrial flow model building method according to claim 1, **characterized in that** before the importing step, the method further comprises the following steps:
analyzing the industrial flow and decomposing the industrial flow into a plurality of entities, the entities comprising user-defined entities, system-defined entities and parameters; and
dividing the plurality of entities into sets, each set of entities comprising a user-defined entity and a system-defined entity, or a user-defined entity, a system-defined entity and a parameter, wherein each set of entities represents a different industrial process.

4. The graph-based industrial flow model building method according to claim 3, **characterized in that** the industrial flow comprises a plurality of sets of entities, wherein after the set dividing step, the method further comprises the following step:
sorting the plurality of sets of entities of the industrial flow.

5. The graph-based industrial flow model building method according to claim 3, **characterized in that** the industrial flow model building method further comprises the following step: connecting one implementation layer to another implementation layer to indicate that the implementation layer is implemented by another implementation layer.

6. A graph-based industrial flow model building system, comprising:
a processor; and
a memory coupled to the processor, wherein the memory stores instructions that, when executed by the processor, cause an electronic device to perform actions comprising:
importing a set of entities which are based on one industrial flow, to build a graph-based model for the industrial flow,
wherein the set of entities comprises a user-defined entity and a system-defined entity;
querying the graph-based model for the industrial flow for the user-defined entity, and if the user-defined entity is found, obtaining a connection of the user-defined entity, otherwise generating a new implementation layer;
querying the model for an implementation layer of the user-defined entity, and if the implementation layer of the user-defined entity is found, obtaining a connection of the implementation layer of the user-defined entity, otherwise generating a new implementation layer; and
querying the model for the system-defined entity, and if the system-defined entity is found, obtaining a connection of the system-defined entity, otherwise generating a new implementation layer, and
iteratively performing the above actions until a final graph-based model for the industrial flow is obtained.

7. The graph-based industrial flow model building system according to claim 6, **characterized in that** the set of entities comprises a user-defined entity, a system-defined entity and a parameter, and the actions further comprise:
querying the model for the parameter, and if the parameter is not found, generating a new implementation layer.

8. The graph-based industrial flow model building system according to claim 6, **characterized in that** before the importing action, the actions further comprise:
analyzing the industrial flow and decomposing the industrial flow into a plurality of entities, the entities comprising user-defined entities, system-defined entities and parameters; and
dividing the plurality of entities into sets, each set of entities comprising a user-defined entity and a system-defined entity, or a user-defined entity, a system-defined entity and a parameter, wherein each set of entities represents a different industrial process.

9. The graph-based industrial flow model building system according to claim 8, **characterized in that** the industrial flow comprises a plurality of sets of entities, wherein after the set dividing action, the actions further comprise:
sorting the plurality of sets of entities of the industrial flow.

10. The graph-based industrial flow model building system according to claim 8, **characterized in that** the actions further comprise: connecting one implementation layer to another implementation layer to indicate that the implementation layer is implemented by another implementation layer.

11. A graph-based industrial flow model building apparatus, comprising:
an importing means, which imports a set of entities which are based on one industrial flow, to build a graph-based model for the industrial flow, wherein the set of entities comprises a user-defined entity and a system-defined entity;
a first query means, which queries the graph-based model for the industrial flow for the user-defined entity, and if the user-defined entity is found, obtains a connection of the user-defined entity, otherwise generates a new implementation layer;
a second query means, which queries the model for an implementation layer of the user-defined entity, and if the implementation layer of the user-defined entity is found,
obtains a connection of the implementation layer of the user-defined entity, otherwise generates a new implementation layer; and
a third query means, which queries the model for the system-defined entity, and if the system-defined entity is found, obtains a connection of the system-defined entity, otherwise generates a new implementation layer.

12. A computer program product tangibly stored on a computer-readable medium and comprising computer-executable instructions that, when executed, cause at least one processor to perform the method according to any one of claims 1 to 5.

13. A computer-readable medium having stored thereon computer-executable instructions that, when executed, cause at least one processor to perform the method according to any one of claims 1 to 5.
